# EUROPEAN PATENT APPLICATION

(11) **EP 1 133 066 A1**
(43) Date of publication of application: **12.09.2001**
(21) Application number: 00960963.7
(22) Date of filing: 13.09.2000
(51) Int. Cl.: H04B 1/40, H04L 27/01, H03H 17/02, H03H 17/06, H03H 21/00

(54) **TRANSMITTER/RECEIVER**

(30) Priority: 29.09.1999 JP 27738699; 18.01.2000 JP 2000009267
(71) Applicant: MATSUSHITA ELECTRIC INDUSTRIAL CO., LTD., Kadoma-shi, Osaka 571-8501 (JP)
(72) Inventor: KITAGAWA, Keiichi, Yokosuka-shi, Kanagawa 239-0847 (JP); SAITO, Yoshiko, Yokosuka-shi, Kanagawa 239-0806 (JP); UESUGI, Mitsuru, Yokosuka-shi, Kanagawa 238-0048 (JP)
(74) Representative: Grünecker, Kinkeldey, Stockmair & Schwanhäusser Anwaltssozietät
(86) International application number: JP0006241
(87) International publication number: WO0124390

(57) **Abstract**

The compensation of a DC offset, an I/Q level ratio, the turbulence of I/Q orthogonality, a synchronous shift, and a phase rotation owing to differences between feeder lines, all being primary factors of waveform distortion that is fixedly added to a reception signal, is realized by digital signal processing. Consequently, the compensation operation can be performed by simple processing. Thereby, each compensation operation that was conventionally complex can be omitted.

## Description

### Technical Field

The present invention relates to a transmit-receive apparatus to be used in a digital radio communication system.

### Background Art

As primary factors of waveform distortion that is fixedly added in a transmit-receive apparatus provided to a communication terminal apparatus such as a mobile station, a base station apparatus and other apparatuses in a digital radio communication system, a DC offset, an I/Q level ratio, the turbulence of an I/Q orthogonality, a synchronous shift, a phase rotation owing to differences between feeder lines, and other causes can be considered. In a conventional transmit-receive apparatus, these primary factors are separately adjusted.

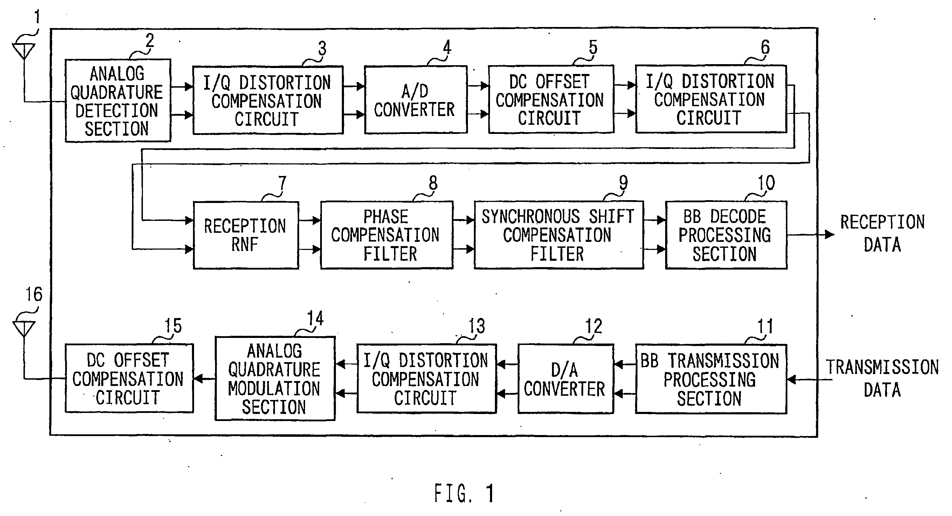

FIG. 1 is a block diagram showing the configuration of the conventional transmit-receive apparatus. A signal received by an antenna 1 is transmitted to an analog detection section 2, and the signal is analogously detected there. The analogously detected signal is transmitted to an I/Q distortion compensation circuit 3, and the I/Q distortion of the signal is compensated. In the I/Q distortion compensation, the voltages of I/Q are measured with an oscilloscope or other equipment, and the voltages are corrected so that the waveform becomes a circle when I and Q are set as X-Y axes, respectively. And then, the I/Q level ratio and the orthogonal turbulence are analogously adjusted. The signal the I/Q distortion of which has been compensated is transmitted to an A/D converter 4, and the signal is converted to a digital signal there.

The thus obtained digital signal is transmitted to a DC offset compensation circuit 5, and the DC offset of the signal is compensated. In the DC offset compensation, the voltage level that is measured in a state that the input terminal of the DC offset compensation circuit 5 is terminated is measured, and the DC offset compensation circuit 5 is analogously adjusted so that the measured voltage level becomes zero. Moreover, I/Q distortion that is added at the A/D converter 4 is compensated by the I/Q distortion compensation circuit 6 similarly to the aforesaid.

The signal the DC offset of which has been compensated is transmitted to a reception root Nyquist filter (RNF) 7, and the filtering of the signal is performed. The filtered signal is transmitted to a phase compensation filter 8, and the phase differences owing to differences between feeder lines are compensated by the passing through of the signal of a phase rotation filter.

Next, the signal the phase of which has been compensated is transmitted to a synchronous shift compensation filter 9, and the synchronous shift of the signal is compensated there. In the synchronous shift compensation, if a considerable range is, for example, ± T/2 ("T" is one symbol time), a synchronous shift is absorbed by the insertion of a digital filter in which the interval of the taps thereof is T/2 and the number of the taps is three and further all of the filter factors thereof are one. The signal each primary factor of which has thus been compensated is transmitted to a base band (BB) decode processing section 10, and the signal is decoded to be reception data.

On the other hand, transmission data is transmitted to a BB transmission processing section 11, and the digital modulation processing and other processing of the data are performed there. The digitally modulated signal is transmitted to a D/A converter 12, and the signal is converted to an analog signal. The obtained analog signal is transmitted to an I/Q distortion compensation circuit 13, and the I/Q distortion of the signal is compensated there likewise in the I/Q distortion compensation circuit 3 on the reception side.

The signal the I/Q distortion of which has been compensated is transmitted to an analog quadrature modulation section 14, and the signal is modulated by an analog quadrature modulation there. The signal that has been modulated by the analog quadrature modulation is transmitted to a DC offset compensation circuit 15, and the DC offset of the signal is compensated there. In the DC offset compensation, carrier leak measurement (the measurement of how much leakage into a carrier frequency is observed by means of a spectrum analyzer or other measurement equipment at an IF step or other steps by the inputting of a non-modulated carrier) is performed, and the DC offset of the signal is analogously adjusted so that the measurement value is equal to a desired level or less. The signal the DC offset of which has thus been compensated is transmitted through an antenna 16.

As described above, the conventional transmit-receive apparatus separately performs the compensation relating to each distortion component, and the apparatus realizes the compensation by following very troublesome processes.

### Disclosure of Invention

An object of the present invention is to provide a transmit-receive apparatus capable of compensating primary factors of waveform distortion added to a reception signal easily.

The subject matter of the present invention is to realize the compensation of a DC offset, an I/Q level ratio, the turbulence of I/Q orthogonality, a synchronous shift, a phase rotation owing to differences between feeder lines, all being primary factors of the waveform distortion added to a reception signal fixedly, by means of digital signal processing.

### Brief Description of Drawings

FIG. 1 is a block diagram showing the configuration of a conventional transmit-receive apparatus;
FIG. 2 is a block diagram showing the configuration of a transmit-receive apparatus according to an embodiment of the present invention;
FIG. 3 is a block diagram showing the configuration of an I/Q distortion & synchronous shift & phase compensation filter of the transmit-receive apparatus having the aforesaid configuration;
FIG. 4 is a diagram showing the configuration of a filter in the I/Q distortion & synchronous shift & phase compensation filter shown in FIG. 3;
FIG. 5 is a diagram for illustrating the configuration method of the I/Q distortion & synchronous shift & phase compensation filter shown in FIG. 2;
FIG. 6 is a block diagram showing a part of the configuration of a transmit-receive apparatus according to a second embodiment of the present invention; and
FIG. 7 is a block diagram showing a part of the configuration of a transmit-receive apparatus according to a third embodiment of the present invention.
Best Mode for Carrying Out the Invention

Hereinafter, embodiments of the present invention will be described in detail by reference to the attached drawings.

### (EMBODIMENT 1)

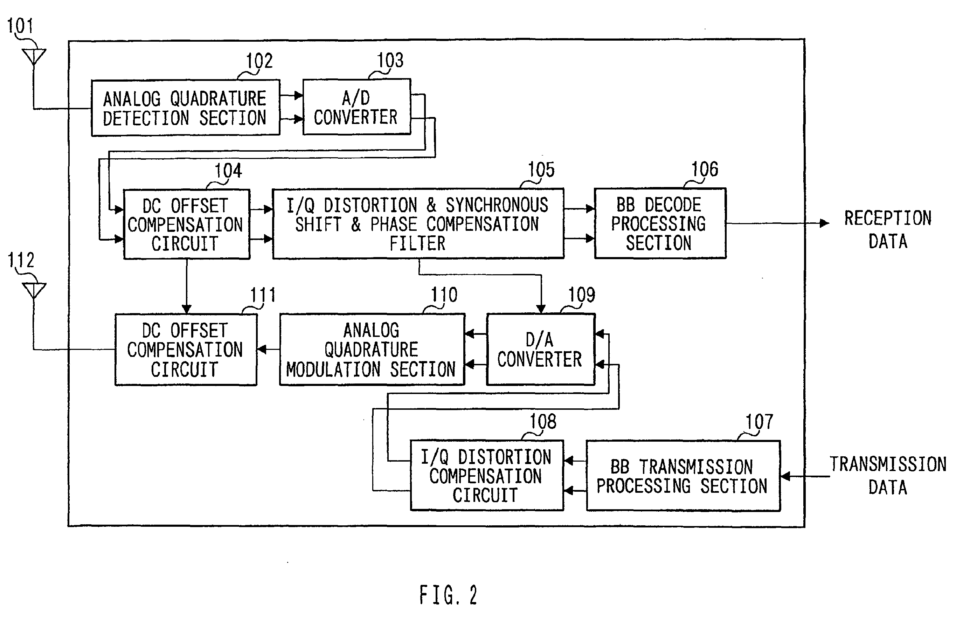

FIG. 2 is a block diagram showing the configuration of a transmit-receive apparatus according to the embodiment 1 of the present invention. On the side of a receiver, a signal received by an antenna 101 is transmitted to an analog quadrature detection section 102, and the analog quadrature detection of the signal is performed there. The signal that has been detected by the analog quadrature detection is transmitted to an A/D converter 103, and the signal is converted to a digital signal there. Now, the signal after the A/D conversion is in a state that a DC offset, I/Q distortion, a synchronous shift, and phase distortion are added.

The thus obtained digital signal is transmitted to a DC offset compensation circuit 104, and the DC offset of the signal is compensated. In the DC offset compensation, random data having equal occurrence probabilities of "+" and "-" are simply added to each other for a certain fixed interval, and the compensation is performed by setting the result of the addition as a DC component. That is, the reason is that, because the values of the random data themselves are canceled owing to the equal occurrence probabilities of "+" and "-" and only the DC offset is left, the DC offset can be utilized as the DC component. To put it concretely, when there is an offset of "α" and "x" samples are added, "x × α" is obtained, and accordingly the DC offset can finally be obtained by the division of the result of the addition by "x". Incidentally, by the pre-selection of "x" to be an exponentiation of two, the DC offset can be obtained not by the division but by bit shifting, and consequently, the DC offset can be obtained more easily.

By the performance of the DC offset using such random data having the equal occurrence probabilities of "+" and "-", the DC offset compensation can be executed by the simple digital processing of the mere addition in a prescribed signal interval. Thereby, troublesome adjustment operation can be omitted.

The signal the DC offset of which has been compensated is transmitted to an I/Q distortion & synchronous shift & phase compensation filter (hereinafter referred to as "digital filter") 105, and the I/Q distortion, the synchronous shift and the phase of the signal are compensated there by digital signal processing. The signal that has been compensated by these pieces of compensation is transmitted to a base band (BB) decode processing section 106, and the signal is decoded there to be reception data.

On the other hand, on the side of a transmitter, transmission data is transmitted to a BB transmission processing section 107, and the digital modulation processing and other processing of the data are performed there. In an I/Q distortion compensation circuit 108, a filter having the same configuration as that of the digital filter 105 is used, and the inverse distortion of the I/Q distortion that will be added in a D/A converter 109 and an analog quadrature modulation section 110 in subsequent stages is added as a compensation value. The inverse distortion of the phase distortion is also added here. The digitally modulated signal is transmitted to a D/A converter 109, and the signal is converted to an analog signal.

The signal the I/Q distortion of which has been compensated is transmitted to an analog quadrature modulation section 110, and the signal is modulated by an analog quadrature modulation there. The signal that has been modulated by the analog quadrature modulation is transmitted to a DC offset compensation circuit 111, and the DC offset of the signal is compensated there. The DC offset compensation is performed likewise in the reception side. The signal the DC offset of which has thus been compensated is transmitted through an antenna 112.

There is a case where the same integrated circuit (IC) is used in the analog quadrature detection section 102 on the reception side and the analog quadrature modulation section 110 on the transmission side in the transmit-receive apparatus. In this case, the filter factors obtained at the digital filter 105 on the reception side are transmitted to the I/Q distortion compensation, circuit 108 on the transmission side, and a digital filter may be configured in the I/Q distortion compensation circuit 108 by the use of the input filter factors for giving the inverse distortion. Thereby, the calculation quantity in the apparatus can be decreased and the load of the apparatus can be reduced.

Moreover, in this case, the offset compensation value obtained by the DC offset compensation circuit 104 on the reception side is transmitted to the DC offset compensation circuit 111 on the transmission side, and the DC offset compensation of an analog signal after the quadrature modulation is performed by the use of the offset compensation value that has been obtained from the reception side. Thereby, the calculation quantity in the apparatus can be decreased and the load of the apparatus can be reduced.

Next, the operation of the digital filter 105 in the aforesaid transmit-receive apparatus will be described.

The digital filter 105 is one to compensate the distortion other than the DC offset collectively. Moreover, the digital filter 105 is configured so as to include a route Nyquist filter, too. Then, because the filter factors are obtained so that the signal-to-noise ratio (SNR) of the filter becomes largest, the performance (noise immunity) of the transmit-receive apparatus can be more improved than the conventional one. Moreover, because the digital filter 105 is configured so as to include also the root Nyquist filter, the scale of the hardware thereof can be made small.

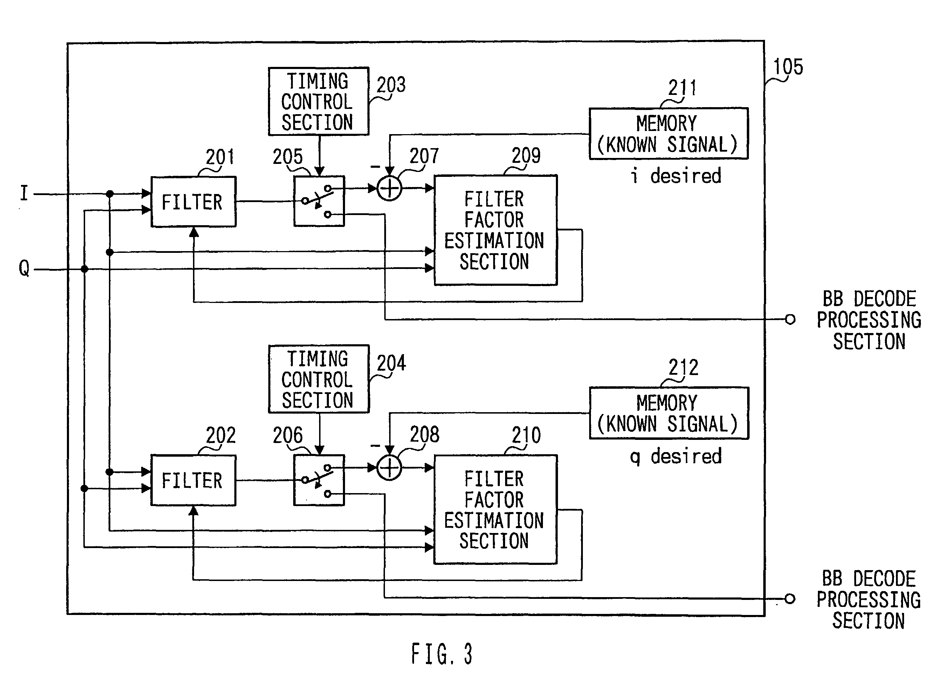

The digital filter 105 has the configuration shown in FIG. 3. The digital filter 105 comprises filters 201, 202 for compensating I/Q distortion, phase distortion and a synchronous shift, switches 205, 206 for performing the switching to filter factor estimation sections 209, 210 to be used at the time of the setting of the filter factors of the filters 201, 202, timing control sections 203, 204 for controlling the timing of the switches 205, 206, and memories 211, 212 for storing an i_{desired} signal and a q_{desired} signal that are known signals necessary at the time of the configuration of the filters.

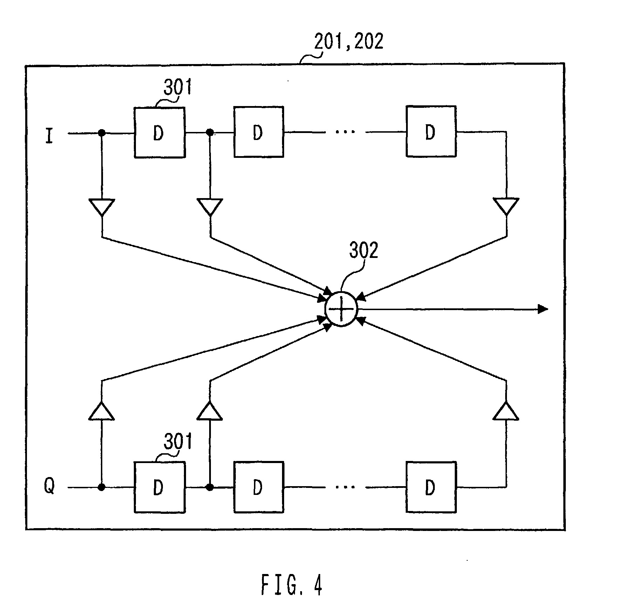

Moreover, the filters 201, 202 are configured, as shown in FIG. 4, to comprise a plurality of delay elements 301 that are arranged severally and that are for an I (in-phase component) signal and a Q (quadrature component) signal, and an adder 302 for adding a reception signal and the output of each delay element 301.

The filter factors of the digital filter 105 are for canceling the distortion added inherently and steadily to the transmit-receive apparatus. Accordingly, the filter factors may once be obtained at such a time of the turning on of the power supply of the transmit-receive apparatus.

Now, at first, when the filter factors are to be obtained at such a time of the turning on of the power supply, the timing control sections 203, 204 output control signals to the switches 205, 206, and switch the switches 205, 206 to the filter factor estimation sections 209, 210. When the filter factors are estimated, the known signals stored in the memories 211, 212 and a reception signal are respectively added by the adders 207, 208, and the differences between both of them are calculated to be output to the filter factor estimation sections 209, 210. The filter factor estimation sections 209, 210 set the filter factors in conformity with prescribed algorithm. The set filter factors are sent to the filters 201, 202, and then the filters 201, 202 are configured.

After the filters 201, 202 have been configured, the timing control sections 203, 204 output control signals to switches 205, 206 to switch the switches 205, 206 to the output terminals to the BB decode processing section 106. After that, the reception signal passes through the filters 201, 202 and the signal is output to the BB decode processing section 106 in a state that the I/Q distortion, the synchronous shift and the phase distortion of the signal are compensated.

Because the filters 201, 202 have the plural delay elements 301 as shown in FIG. 4, the synchronous shift can be absorbed by the delay processing of the delay elements 301. Moreover, by the passing through of the reception signal of the filters 201, 202 set by the use of the filter factors obtained by the aforesaid filter factor estimation sections 209, 210, the I/Q distortion and the phase distortion that are added to the reception signal at the analog quadrature detection section 102 can be compensated.

As described above, the filter factors of the filters 201, 202 may only once be obtained at such a time of the turning on of the power supply, and the calculations for the filter factors become unnecessary in the distortion compensation operations after that, and consequently the load of the apparatus for setting the filter factors can be reduced.

Next, the configuration method of the filters 201, 202 will be described. For the simplification of the description, a case where the filters 201, 202 have severally one tap and the IQ level ratio of an input signal is 2:1 is taken up as an example. Incidentally, four real numbers ("a", "b", "c", "d") that will be described in the following are obtained for the number of the taps.

At first, for the detection of the DC offset component, in-phase components and quadrature components are severally simply added to each other for a certain signal interval, and the obtained addition results are divided by the number of samples that were added. Then, the quotients are subtracted as the DC offset components from a reception signal.

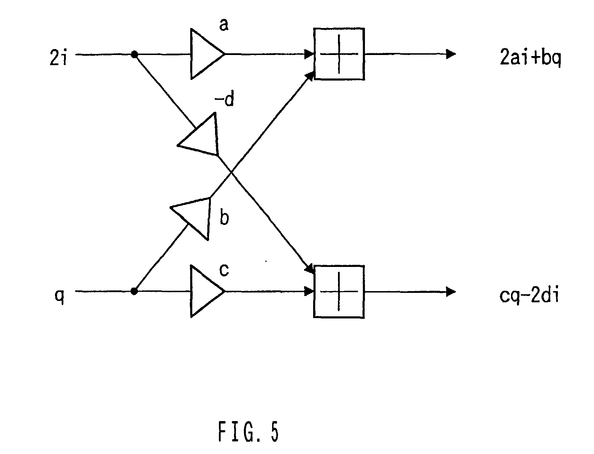

Next, by the so-called four-real number filter shown in FIG. 5, the filter factors concerning in-phase components (I) are made to be converged. Here, the least mean square (LMS) algorithm, the recursive least square (RLS) algorithm, or other algorithm, in which the minimization of the square of estimated errors is made to be an criterion, can be utilized as the convergence algorithm of the filter factors.

From FIG. 5, (2i + jq) · (a - jb) = (2ai + bq) + j(aq - 2bi) is obtained. Here, the error to be used in the LMS (or the RLS) is supposed to be i_{desired} - (2ai + bq) with attention only to the in-phase component, and then (a, b) are converged so that the error becomes minimum. In this example, the finally obtainable (a, b) should be (0.5, 0.0).

Next, by the so-called four-real number filter shown in FIG. 5, the filter factors concerning quadrature components (Q) are made to be converged. From FIG. 5, (2i + jq) · (c - jd) = (2ci + dq) + j(cq - 2di) is obtained. Here, the error to be used in the LMS (or the RLS) is supposed to be q_{desired} - (cq - 2di) with attention only to the quadrature component, and then (c, d) are converged so that the error becomes minimum. In this example, the finally obtainable (c, d) should be (1.0, 0.0).

By the repetition of the aforesaid convergence processing during a known signal interval, a filter factor is finally obtained. That is, the tap coefficient of the in-phase component and the tap coefficient of the quadrature component are independently estimated. A filter that is configured by using the obtained filter factors is the digital filter in the present embodiment (or the filters 201, 202 in FIG. 3).

Moreover, by the assignment of the coefficient (real number) of the route Nyquist filter to the in-phase component as an initial value in the aforesaid convergence processing, the convergence properties can also be improved.

As described above, because the transmit-receive apparatus according to the present embodiment collectively compensates I/Q distortion, a synchronous shift, phase distortion other than a DC offset, namely the distortion and the synchronous shift that are generated in analog circuits from the end of an antenna to an A/D conversion by means of digital signal processing, the compensation operation can be performed by simple processing. Thereby, each compensation operation which was conventionally complex can be omitted.

### (EMBODIMENT 2)

The digital filter described in the embodiment 1, i.e. the four-real number filter, can be applied to the equalizer of a transmit-receive apparatus. In the following embodiments 2, 3, cases where the digital filter described in the embodiment 1 are applied to the equalizer.

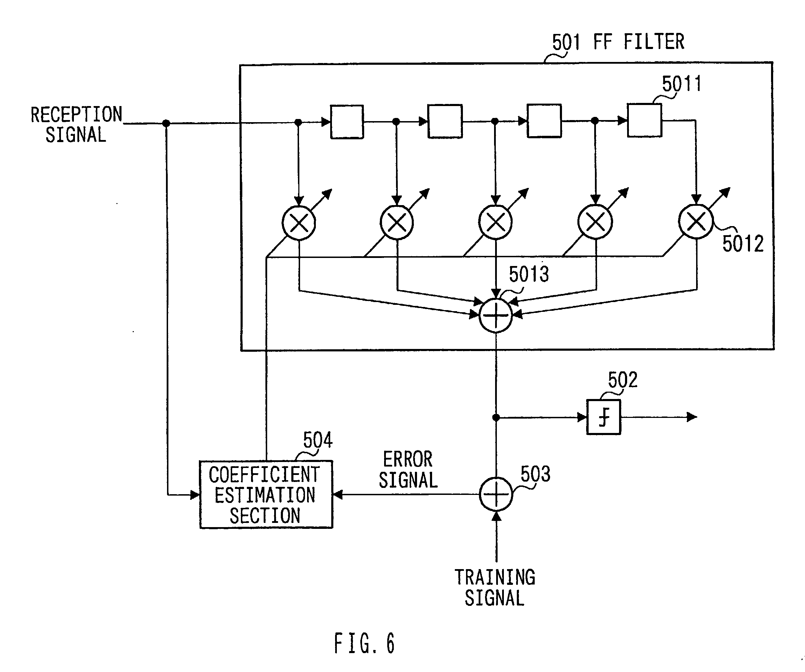

FIG. 6 is a block diagram showing a part of the configuration of a transmit-receive apparatus according to the embodiment 2 of the present invention.

The configuration is an equalizer having a feed forward tap filter (hereinafter, referred to as "FF filter"), and the configuration makes it possible to perform the effective equalization filtering processing of a reception signal under the condition that a delay wave is larger than a direct wave.

That is, the equalizer shown in FIG. 6 comprises an FF filter 501 for performing the equalization filtering processing of a reception signal, a data judgment section 502 for judging a signal after the equalization filtering processing, an adder 503 for outputting the difference between the signal that has been processed by the FF filtering processing and a training signal that is a known signal, and a coefficient estimation section 504 for estimating a tap coefficient of the FF filter 501 by treating the output of the adder 503 as an error signal.

Moreover, the FF filter 501 includes delay units 5011 for delaying a reception signal, multipliers 5012 for multiplying the reception signal by an FF tap coefficient, and an adder 5013 for adding the multiplication results.

In the equalizer having the aforesaid configuration, at first, the estimation of the FF tap coefficient is performed by the use of the training interval of a reception signal. The reception signal is input into the FF filter 501 and the equalization filtering processing thereof is performed. To put it concretely, the reception signal is delayed by the delay units 5011, and is multiplied by the FF tap coefficient at each multiplier 5012. Then, the results of the respective multiplication are added with each other by the adder 5013. The signal after the addition is subtracted from a known training signal, and an error signal is generated. The error signal is output to the coefficient estimation section 504. The coefficient estimation section 504 converges the tap coefficients "a", "b" of the in-phase component and the tap coefficients "c", "d" of the quadrature component severally independently so that the error signal becomes minimum in conformity with the LMS (or RLS) algorithm or other algorithm likewise in the embodiment 1. The thus obtained tap coefficients "a", "b", "c", "d" are output to the multipliers 5012 of the FF filter 501.

For the information signal that is input successively to the training signal of the reception signal, the equalization filtering processing is performed on the basis of the obtained tap coefficients "a", "b", "c", "d". The information signal that has been processed by the equalization filtering processing is judged by the judgment section 502.

Because the waveform shaping of a reception signal in a distorted state can be performed in the equalizer of a transmit-receive apparatus of the present embodiment differently from the conventional complex filter that performs the distortion compensation on the basis of a phase rotation and an amplitude variation, it becomes possible to perform the distortion compensation that cannot be compensated only by the phase rotation and the amplitude variation. Thereby, the transmit-receive apparatus according to the present embodiment can improve its reception performance.

### (EMBODIMENT 3)

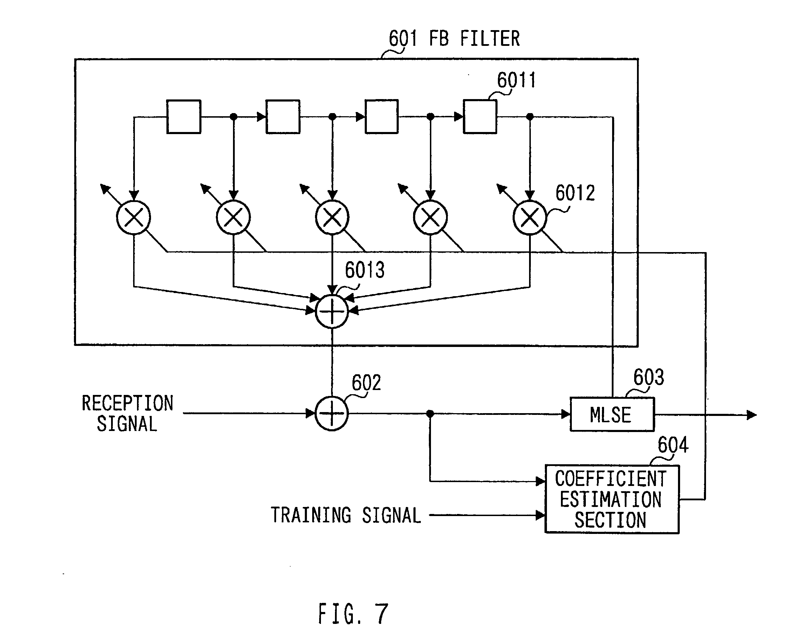

FIG. 7 is a block diagram showing a part of the configuration of a transmit-receive apparatus according to the embodiment 3 of the present invention.

The configuration is an equalizer having a filter of a feedback tap (hereinafter, referred to as "FB filter"), and the configuration makes it possible to perform the effective equalization processing of a reception signal by utilizing not only a direct wave but also the reception signal predicted value (replica) of a delayed wave generated by using the FB filter.

That is, the equalizer shown in FIG. 7 comprises a FB filter 601 for generating a reception signal predicted value (replica) from a judgment signal by the MLSE or a known training signal, an adder 602 for outputting the difference between the generated replica and a reception signal, maximum likelihood sequence estimation (MLSE) 603 for performing the estimation of a transmitted signal on the basis of an error signal between the replica and the reception signal, and a coefficient estimation section 604 for estimating the tap coefficient of the FB filter 601 by the use of the difference between the training signal that has been processed by the FB filtering processing and the reception signal as the error signal.

Moreover, the FB filter 601 includes delay units 6011 for delaying a reception signal, multipliers 6012 for multiplying the reception signal by an FB tap coefficient, and an adder 6013 for adding the multiplication results to each other.

In the equalizer having the above configuration, a training signal that is the known signal is input into the coefficient estimation section 604, and in the coefficient estimation section 604, the coefficient of the FB tap of the FB filter 601 is estimated on the basis of the training signal. The coefficient of the FB tap is output to the multipliers 6012 of the FB filter 601.

When the training signal part of the reception signal is input into the FB filter 601, the equalization filtering processing of the training signal is performed. To put it concretely, the training signal is delayed by the delay units 6011 and each of the delayed training signals is multiplied by the coefficient of the FB tap by the multipliers 6012. And then, the respective multiplication results are added to each other by the adder 6013.

The training signal that has been processed by such equalization filtering processing is added (or subtracted) with (or from) the known training signal at the adder 602, and then the error signal is obtained. The obtained error signal is output to the coefficient estimation section 604.

The coefficient estimation section 604 converges the tap coefficients "a", "b" relative to the in-phase component and the tap coefficients "c", "d" relative to the quadrature component in conformity with the algorithm such as the LMS (or the RLS) severally independently so that the error signal becomes minimum similarly to the embodiment 1. The thus obtained tap coefficients "a" , "b", "c", "d" are output to the multipliers 6012 of the FB filter 601.

To the information signal that is input successively to the training signal of the reception signal, an error signal is generated by the subtraction of the replica that is an output of the adder 6013 from the reception signal. The error signal is input into the MLSE 603, and the MLSE 603 performs the maximum likelihood sequence estimation on the basis of the error signal to output a transmission signal candidate. The transmission signal candidate is input into the FB filter 601 and a replica is generated. The processing is repeatedly performed and the decode processing of the reception signal is performed.

Because the distorted replica signals of a direct wave and a delayed wave in accordance with the distortion of reception can be generated in the equalizer of a transmit-receive apparatus of the present embodiment differently from the conventional complex filter that performs the distortion compensation on the basis of a phase rotation and an amplitude variation, it becomes possible to perform the distortion compensation that cannot be compensated only by the phase rotation and the amplitude variation. Thereby, the transmit-receive apparatus according to the present embodiment can improve its reception performance.

Although a case where the MLSE is used is described in the embodiment 3, a decision feedback equalizer (DFE) may also be applied to the present embodiment in place of the MLSE.

The FF filter described in respect of the embodiment 2 and the FB filter described in respect of the embodiment 3 can fittingly be used together. Thereby, it is possible to give full play of the prominent reception performance in both of the cases where the level of a direct wave is higher than that of a delayed wave and vice versa. Moreover, when the FF filter and the FB filter are used together, the digital filter according to the present invention may be applied to either of the FF filter and the FB filter. Incidentally, when the MLSE is used in the case where the FF filter and the FB filter are used together, it is preferable to fix one of the FB taps to be one for the avoidance of the case where all of the tap coefficients become zero.

The digital filters of the transmit-receive apparatuses according to the aforesaid embodiments 1-3 may have a configuration in which the digital filters also operate as another filter in the apparatus. Thereby, the processing of the collective compensation of distortion and a synchronous shift and the original filter processing of the transmit-receive apparatus can collectively be performed, and the load of the apparatus can consequently be reduced.

Moreover, the digital filters of the transmit-receive apparatuses according to the aforesaid embodiments 1-3 can also be applied to the compensation for phase rotations between antenna elements of an adaptive array antenna. To put it concretely, the present digital filters may be configured to compensate the phase rotation owing to differences between feeder lines between the antenna elements.

The transmit-receive apparatus of the present invention can be applied to a communication terminal apparatus such as a base station apparatus and a mobile station in a digital radio communication system.

The present invention is not limited to the aforesaid embodiments, and can be implemented by being variously changed. For example, the configuration method of the digital filter is not limited to the methods described above. Moreover, the aforesaid embodiments 1-3 can be implemented by combining each of them appropriately.

A transmit-receive apparatus of the present invention is characterized by a first digital filter for compensating collectively distortion and a synchronous shift in a reception signal, the distortion and the synchronous shift being generated in analog processing from an antenna end to A/D conversion.

A transmit-receive apparatus of the present invention has a configuration comprising: a receiver including a first digital filer for compensating collectively distortion and a synchronous shift in a reception signal, the distortion and the synchronous shift being generated in analog processing from an antenna end to A/D conversion; and a transmitter including a second digital filter for giving an inverse characteristic for compensating distortion given to a transmission signal owing to D/A conversion.

According to these configurations, because I/Q distortion, a synchronous shift, phase distortion other than a DC offset are collectively compensated by digital signal processing, the compensation operation can be performed by simple processing. Thereby, each compensation operation that was conventionally complex can be omitted.

A transmit-receive apparatus of the present invention has a configuration wherein the first and the second digital filters also function as another filter in the apparatus severally in the aforesaid configuration.

According to the configuration, the processing of the collective compensation of the distortion and the synchronous shift and the original filter processing of the transmit-receive apparatus can collectively be performed, and the load of the apparatus can consequently be reduced.

A transmit-receive apparatus of the present invention has a configuration wherein the first and the second digital filters severally include a filter to be configured by setting of a filter factor, a filter factor estimation section for estimating the filter factor, a switch section for switching the outputting of the reception signal after passing through the filter to output to the filter factor estimation section or to output the reception signal as a reception output, and a timing control section for controlling the timing of the switching of the switch section in the aforesaid configuration.

According to the configuration, the filter factor of the digital filter may once be obtained at such a time of the turning on of the power supply thereof, and the calculation of the filter factor becomes unnecessary in the subsequent distortion compensation operation. Consequently, the load of the apparatus for the setting of the filter factor can be reduced.

A transmit-receive apparatus of the present invention has a configuration wherein the filter is composed of a plurality of delay elements in the aforesaid configuration.

A transmit-receive apparatus of the present invention has a configuration further comprising a DC offset compensation section for performing the DC offset compensation of a reception signal by means of random data in which occurrence probabilities of "+" and "-" are equal in the aforesaid configuration.

According to the configuration, the DC offset compensation can be executed by the simple digital processing of the mere addition in a prescribed signal interval. Thereby, troublesome adjustment operation can be omitted.

A transmit-receive apparatus of the present invention has a configuration wherein a filter factor set in the first digital filter is used in the second digital filter in the aforesaid configuration.

According to the configuration, a new calculation for setting the filter factor becomes unnecessary on the transmitter side. Consequently, the load of the apparatus can be reduced.

A transmit-receive apparatus of the present invention has a configuration wherein the first and the second filters are configured on a basis of tap coefficients of four sets of real number values, and the coefficient estimation of tap coefficient sets concerning an in-phase component and a quadrature component of a filter output is independently performed in the aforesaid configuration.

A transmit-receive apparatus of the present invention is a transmit-receive apparatus including an equalizer, wherein the equalizer has a configuration comprising a tap coefficient estimation section including a filter configured on a basis of tap coefficients of four sets of real number values, and the coefficient estimation of tap coefficient sets concerning an in-phase component and a quadrature component of a filter output is independently performed in the tap coefficient estimation section.

According to the configuration, because the waveform shaping of a reception signal in a distorted state can be performed differently from the conventional complex filter that performs the distortion compensation on the basis of a phase rotation and an amplitude variation, it becomes possible to perform the distortion compensation that cannot be compensated only by the phase rotation and the amplitude variation. Thereby, the reception performance thereof can be improved.

A transmit-receive apparatus of the present invention has a configuration wherein the tape coefficient is used as at least one of a feed forward tap and a feedback tap in the aforesaid configuration.

According to the configuration, even if a reception signal having distortion is input into an equalizer, it is possible to give full play of the prominent reception performance of the equalizer.

A base station apparatus of the present invention is characterized by the aforesaid transmit-receive apparatus. Moreover, a communication terminal apparatus of the present invention is characterized by the aforesaid transmit-receive apparatus. According to these configurations, because I/Q distortion, a synchronous shift and phase distortion other than a DC offset are collectively compensated by digital signal processing, the compensation operation can be performed by simple processing. Thereby, each compensation operation that was conventionally complex can be omitted in the base station apparatus and the communication terminal apparatus.

As described above, because the transmit-receive apparatus of the present invention collectively compensates I/Q distortion, a synchronous shift and phase distortion other than a DC offset by digital signal processing by means of a digital filter, the compensation operation can be performed by simple processing. Thereby, each compensation operation that was conventionally complex can be omitted. Moreover, because a root Nyquist filter is also contained into the digital filter for obtaining a filter factor so that SNR becomes largest, the performance (noise immunity) in the transmit-receive apparatus can be improved in comparison with the conventional apparatus.

This application is based on the Japanese Patent Applications No. HEI 11-277386 filed on September 29, 1999 and No. 2000-009267 filed on January 18, 2000, entire contents of which are expressly incorporated by reference herein.

### Industrial Applicability

The present invention can be applied to a base station apparatus or a communication terminal apparatus in a digital radio communication system.

## Claims

1. A transmit-receive apparatus comprising a first digital filter for compensating collectively distortion and a synchronous shift in a reception signal, the distortion and the synchronous shift being generated in analog processing from an antenna end to A/D conversion.

2. A transmit-receive apparatus comprising:
a receiver including a first digital filer for compensating collectively distortion and a synchronous shift in a reception signal, the distortion and the synchronous shift being generated in analog processing from an antenna end to A/D conversion; and
a transmitter including a second digital filter for giving an inverse characteristic for compensating distortion given to a transmission signal owing to D/A conversion.

3. The transmit-receive apparatus according to claim 1, wherein said first and said second digital filters also function as another filter in said apparatus severally.

4. The transmit-receive apparatus according to claim 1, wherein said first and said second digital filters severally include a filter to be configured by setting of a filter factor, filter factor estimation means for estimating the filter factor, switch means for switching outputting of the reception signal after passing through said filter to output to said filter factor estimation means or to output the reception signal as a reception output, and timing control means for controlling a timing of the switching of said switch means.

5. The transmit-receive apparatus according to claim 4, wherein said filter is composed of a plurality of delay elements.

6. The transmit-receive apparatus according to claim 1, said apparatus further comprising DC offset compensation means for performing DC offset compensation of the reception signal by means of random data in which occurrence probabilities of "+" and "-" are equal.

7. The transmit-receive apparatus according to claim 1, wherein a filter factor set in said first digital filter is used in said second digital filter.

8. The transmit-receive apparatus according to claim 1, wherein said first and said second filters are configured on a basis of tap coefficients of four sets of real number values, and coefficient estimation of tap coefficient sets concerning an in-phase component and a quadrature component of a filter output is independently performed.

9. A transmit-receive apparatus including an equalizer, wherein said equalizer comprises a filter configured on a basis of tap coefficients of four sets of real number values, and coefficient estimation of tap coefficient sets concerning an in-phase component and a quadrature component of a filter output is independently performed.

10. The transmit-receive apparatus according to claim 9, wherein the tape coefficient is used as at least one of a feed forward tap and a feedback tap.

11. A base station apparatus including a transmit-receive apparatus, said transmit-receive apparatus comprising a first digital filter for compensating collectively distortion and a synchronous shift in a reception signal, the distortion and the synchronous shift being generated in analog processing from an antenna end to A/D conversion.

12. A communication terminal apparatus including a transmit-receive apparatus, said transmit-receive apparatus comprising a first digital filter for compensating collectively distortion and a synchronous shift in a reception signal, the distortion and the synchronous shift being generated in analog processing from an antenna end to A/D conversion.
